# FASCICULE DE BREVET EUROPEEN

(11) **EP 0 514 227 B1**
(45) Date de publication et mention de la délivrance du brevet: **21.09.1994**
(21) Numéro de dépôt: 92400985.5
(22) Date de dépôt: 08.04.1992
(51) Int. Cl.: H05K 7/14

(54) **Carte de circuits imprimés, panier et machine incorporant une telle carte**
Gedruckte Leiterplatte, Paneel und die Leiterplatte aufnehmende Maschine
Printed circuit board, panel and machine incorporating such a board

(30) Priorité: 06.05.1991 FR 9105521
(43) Date de publication de la demande: 19.11.1992
(73) Titulaire: BULL S.A., 92800 Puteaux (FR)
(72) Inventeur: Franconville, Françoise, F-75116 Paris (FR); Petiot, Gérard, F-75116 Paris (FR); Robin, Serge, F-75116 Paris (FR)
(74) Mandataire: Denis, Hervé

(56) Documents cités:
- EP-A- 0 129 883
- DE-A- 3 509 380
- IBM TECHNICAL DISCLOSURE BULLETIN, vol. 32, no. 9A, février 1990, pages 50-52, Armonk, NY, US; "Card guide bezel combination and multi-purpose insert/extract latch"

## Description

L'invention se rapporte aux cartes de circuits imprimés, et plus particulièrement aux cartes normalisées, destinées à un panier de machine de traitement de signaux, telle qu'un ordinateur.

Une carte de circuits imprimés est faite d'une plaque multicouche de circuits imprimés fixée à un panneau appelé couramment face avant (cf. par exemple EP-A- 0 129 883 et DE-A- 3 509 380. La carte est ordinairement placée verticalement dans un panier. Un panier est une boîte métallique ayant sa surface avant ouverte pour l'introduction et la sortie des cartes et sa face arrière, dite fond de panier, sert principalement à l'interconnexion des cartes et à leur alimentation. Les dimensions d'une carte se réfèrent à sa position verticale dans le panier. La face avant est ordinairement un profilé métallique en U. Les extrémités de la face avant sont fixées par vis aux coins du côté avant de la plaque de circuits imprimés, par l'intermédiaire de dispositifs de fixation. La plaque porte les composants sur une face, dite face active, et présente les soudures des pattes des composants sur l'autre face, dite face de soudure (à la vague). La plaque est fixée entre les ailes de la face avant, parallèlement à elles, de façon que sa face de soudure soit légèrement en retrait d'une aile de la plaque. La face avant délimite l'espace maximal que peut occuper la plaque et ses composants dans le panier. Les composants sont notamment des circuits intégrés et des connecteurs. Les connecteurs se répartissent sur l'arrière de la plaque de circuits imprimés pour la connexion de fond de panier, et sur l'avant de la plaque, dits connecteurs frontaux. La face avant présente des ouvertures pour l'enfichage de connecteurs de cordons dans les connecteurs frontaux.

Cette carte pose actuellement deux problèmes majeurs. Le premier problème est dû à la miniaturisation progressive des connecteurs frontaux. Les connecteurs frontaux classiques ont leurs pattes soudées près du bord avant de la plaque de circuits imprimés et leurs corps fixés à la face avant de la carte. La fixation est couramment faite par vis ou par clips et assure la mise à la masse électrique du corps du connecteur frontal par l'intermédiaire de la face avant. Avec les connecteurs frontaux miniatures, il n'est plus possible de les fixer à la face avant de la carte. Ces connecteurs sont alors fixés seulement par leurs fines pattes près du bord avant de la plaque de circuits imprimés. Leur corps n'est pas assez long pour être fixé à la face avant. Leur connexion à un cordon est donc une opération délicate. Le poids du cordon, un mouvement du cordon ou une force exercée sur le cordon suffit pour endommager les connecteurs ayant peu de pattes. Cet inconvénient oblige une manipulation de la carte par un homme du métier, contrairement à l'évolution qui tend à permettre la réparation par l'utilisateur de la machine. En plus de cet inconvénient, le connecteur frontal n'a plus son corps à la masse et peut donc être perturbé par les rayonnements électromagnétiques environnants.

Une solution consisterait à rapprocher la plaque de circuits imprimés de la face avant. Dans ce cas, la face de soudure de la plaque viendrait en partie sous une aile de la face avant. Par conséquent, des pattes des composants sur la face de soudure de la plaque risqueraient de faire contact avec l'aile de la face avant, mise à la masse électrique. En plus de ce risque, la proximité immédiate de l'aile produirait un effet perturbant le fonctionnement des circuits de la carte. D'autre part, cette solution n'est envisageable que pour les rares cas où les cartes peuvent ne pas être normalisées. Pour les cartes normalisées, cette distance est prédéterminée. On pourrait penser à rehausser la carte par rapport à l'aile sous-jacente. Mais cette distance est elle-aussi prédéterminée par les normes ordinaires dans ce domaine.

Une autre solution serait de réduire la largeur des ailes de la face avant. Dans un panier, toutes les faces avant des cartes sont montées en laissant entre elles un espace suffisant pour pallier toutes les marges de tolérance de fabrication. Dans ces conditions, les ailes voisines de deux faces avant montées sur un panier doivent assurer une isolation électromagnétique des cartes du panier par rapport à l'extérieur du panier. Cette isolation est faite ordinairement, soit en augmentant au maximum la largeur des ailes pour en accroître la surface mise à la masse et réduire sensiblement les rayonnements parasites, soit en mettant les ailes voisines régulièrement en contact par des éléments conducteurs, par exemple tous les cinq centimètres environ. La dernière forme d'isolation est beaucoup plus efficace. Une tentative a consisté à disposer des ressorts d'isolation le long d'une aile pour faire un contact souple avec l'aile voisine d'une autre face avant. On verra ultérieurement pourquoi la position des ressorts doit être ajustable. La fixation ajustable des ressorts pose actuellement des problèmes difficilement surmontables. La fixation par pincement de l'aile est la plus simple, mais elle exige une grande assise des ressorts et, par conséquent, une grande largeur des ailes. Enfin, une autre raison qui milite pour garder de larges ailes réside dans la compatibilité généralement requise entre les cartes. Une largeur réduite des ailes d'une carte ne pourrait plus remplir convenablement le rôle d'isolation sans contact avec une carte voisine.

Encore une autre solution pour fixer fermement les connecteurs frontaux miniatures serait d'ajouter des moyens de bridage des corps de ces connecteurs à la face avant. Ces moyens devraient ne pas gêner leur connexion avec le connecteur d'un cordon et s'adapter à tous les nombreux types de connecteurs frontaux. Ces moyens seraient donc coûteux et compliqueraient la structure et leur pose.

Le second problème est relatif à l'emploi de larges connecteurs frontaux, tels que des connecteurs coaxiaux ou des doubles connecteurs miniatures. Le corps de ces connecteurs occupe presque toute la largeur de la face avant. Leur insertion entre les ailes est donc difficile ou impossible. Il faut alors découper des parties d'une aile pour loger ces connecteurs. De plus, les connecteurs de leurs cordons respectifs peuvent être encore plus larges que la surface de connexion de ces connecteurs. Les ouvertures ménagées dans la face avant pour la connexion des cordons doivent alors être élargies en conséquence. Dans de nombreux cas, la face avant est découpée sur toute la largeur d'une aile et sur la majeure partie de la largeur de sa base. A ce niveau, la face avant ne présente donc qu'une aile et une mince bande de métal. Un premier inconvénient réside dans la fragilité de cette face avant. Il faut donc employer un métal rigide et épais, tel que l'acier, au lieu de l'aluminium. Ceci alourdit notablement le panier. En outre, l'augmentation de l'épaisseur aggrave le problème du logement des connecteurs et augmente le nombre des découpes des ailes. Comme second inconvénient, les découpes des ailes des faces avant sont préjudiciables à leur isolation électromagnétique désirée. Elles accroissent les fuites de façon irrémédiable. Dans certains cas, il faut ajouter une plaque d'écran devant le panier pour obtenir l'isolation désirée. Comme troisième inconvénient, la découpe de parties d'aile ne permet plus un positionnement régulier des ressorts d'isolation sur toute la hauteur des deux ailes voisines de deux faces avant. Les ressorts doivent être montés de façon ajustable sur une aile. La façon la plus simple et la plus économique est de les faire en forme de pince sur la largeur de l'aile. Cependant, il s'avère dans la pratique que les forces exercées sur ces ressorts lors de l'insertion ou de la sortie d'une carte d'un panier sont en général assez fortes pour décrocher les ressorts.

L'invention résout les problèmes des cartes de circuits imprimés classiques et remédie à leurs inconvénients. Grâce à l'invention, les connecteurs miniatures peuvent être fixés simplement aux faces avant. Leur connexion aux cordons peut ainsi être laissée à un utilisateur de la machine. En outre, leur blindage peut être assuré. D'autre part, les larges connecteurs frontaux peuvent être logés sans avoir à découper une partie d'aile. De ce fait, les ressorts d'isolation peuvent être montés fixement sur une aile et de façon régulière sur toute leur hauteur.

Une carte de circuits imprimés comprenant une plaque de circuits imprimés pourvue d'un panneau de face avant en forme de U, le panneau comportant une base et deux ailes parallèles à la plaque, est caractérisée en ce que les ailes du panneau sont placées de l'autre côté de la plaque par rapport à la base du panneau.

L'invention s'étend à un panier pour cartes de circuits imprimés, caractérisé en ce qu'au moins un bord de sa surface avant présente des moyens d'isolation électromagnétique adaptés à une carte telle que définie précédemment.

L'invention se rapporte aussi à une machine de traitement de signaux, comprenant au moins un panier pour cartes de circuits imprimés, caractérisée en ce qu' au moins une desdites cartes est celle définie précédemment et/ou le panier est celui défini précédemment.

Les caractéristiques et avantages de l'invention ressortiront de la description qui suit, donnée à titre d'exemple et faite en référence aux dessins annexés.

Dans les dessins :
- la figure 1 est une vue latérale partielle d'une carte de circuits imprimés conforme à l'invention ;
- la figure 2 est une vue en coupe de dessus suivant la ligne II-II de la carte représentée sur la figure 1 ;
- la figure 3 est une vue en perspective de la face avant de la carte représentée sur la figure 1 ;
- la figure 4 est une vue schématique en perspective d'une machine de traitement de signaux comprenant au moins un panier adapté à la réception de cartes conformes à l'invention ; et
- la figure 5 est une vue latérale partielle d'une variante de réalisation d'une carte de circuits imprimés conforme à l'invention fixée au panier de la figure 4.

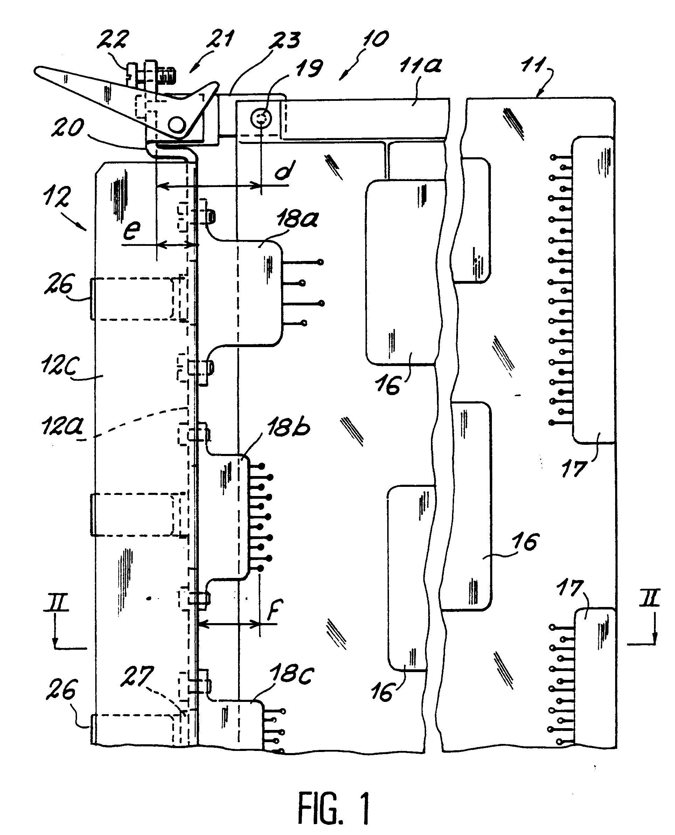

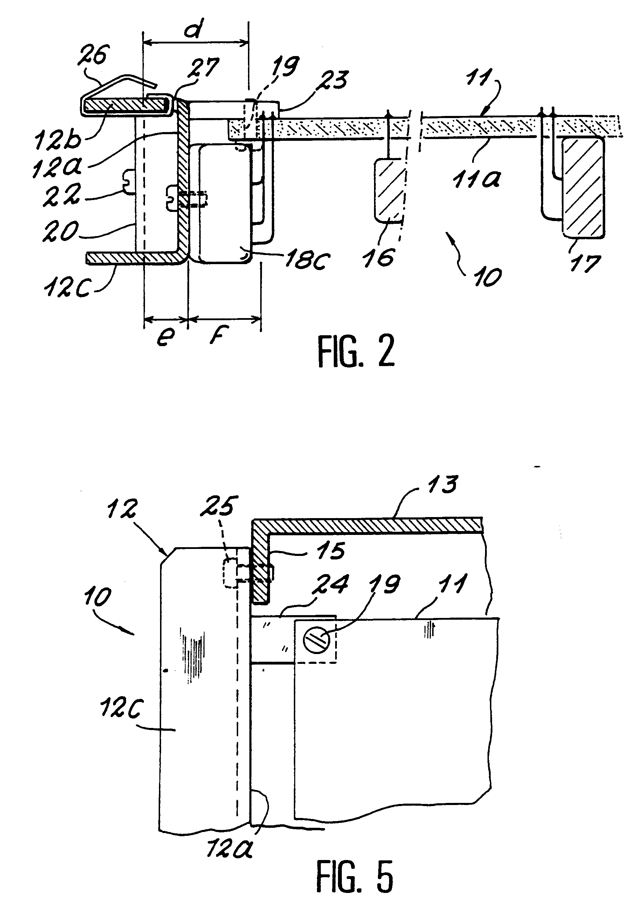

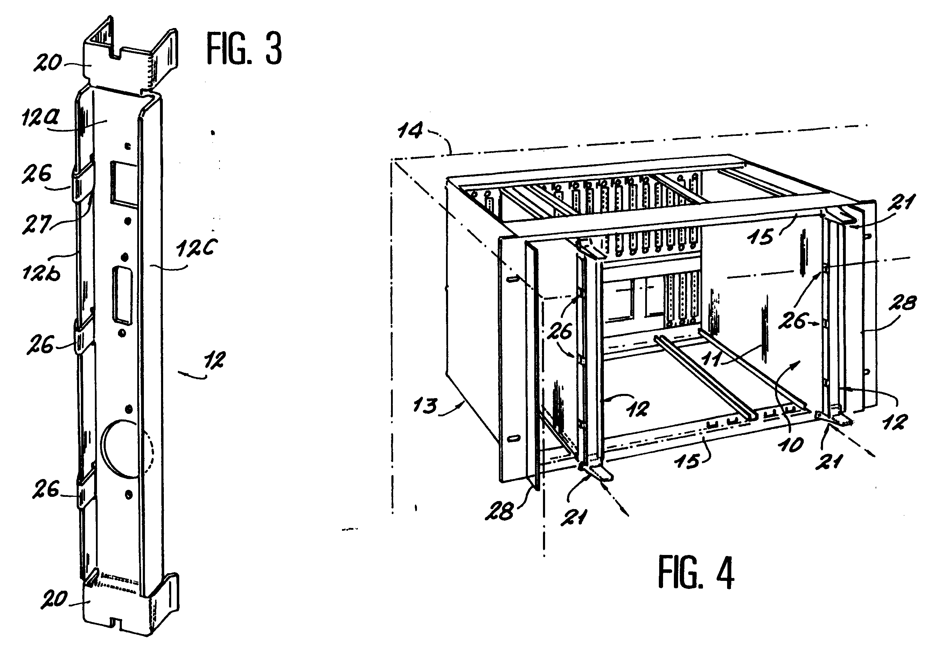

La carte de circuits imprimés 10 conforme à l'invention qui est représentée sur les figures 1 et 2 comprend une plaque multicouche de circuits imprimés 11 pourvue d'un panneau de face avant 12, couramment appelé face avant et vue entièrement en perspective dans la figure 3. Les dessins ne respectent pas les proportions réelles de la carte afin de mieux mettre en évidence les caractéristiques de l'invention. La plaque 11 est représentée dans sa position habituellement verticale dans un panier 13 d'une machine électronique ou informatique 14, telle que représentée schématiquement sur la figure 4. Le panier 13 est un volume parallélépipédique rectangulaire ayant sa surface avant ouverte pour l'insertion ou le retrait des cartes de circuits imprimés sur des rails de guidage hauts et bas (non référencés). En haut et en bas de la surface avant du panier 13, deux barrettes 15 servent à la fixation des cartes. La surface arrière du panier, appelée fond de panier, est garnie de connecteurs de fond de panier.

La carte 10 représentée sur les figures 1 et 2 satisfait à la norme IEEE/ANSI 1296. Elle est plus particulièrement adaptée au dispositif Multibus II (marque enregistrée de Intel Corporation). La plaque 11 représentée de façon partielle porte sur sa face active 11a les composants 16, les connecteurs de fond de panier 17 et les connecteurs frontaux 18. L'autre face présente les soudures faites à la vague des pattes des composants 16 et des connecteurs 17 et 18. Les deux extrémités du côté frontal de la plaque 11 sont percés de deux trous respectifs 19 connectés à la masse électrique de la plaque 11. Les trous 19 servent à la fixation par vis (non référencées) de la face avant 12. La face avant 12 est un panneau métallique, en acier zingué ou en aluminium par exemple, en forme de U. Elle présente une base 12a et deux ailes 12b, 12c parallèles à la plaque 11. Une face avant conforme à l'invention a ses deux ailes placées de l'autre côté de la plaque 11 par rapport à la base 12a de la face avant. Dans les cartes classiques, les ailes 12b, 12c étaient placées du même côté que la plaque 11 à partir de la base 12a de la face avant.

Selon un mode réalisation courant, chaque extrémité haute et basse 20 de la face avant 12 porte un dispositif de fixation 21 de la carte 10 au panier 13. Le dispositif de fixation 21 est ordinairement un extracteur 21 monté sur les extrémités 20 de la face avant 12 et pourvu de moyens de fixation (une vis 22 par exemple) de la face avant de la carte aux barrettes respectives 15 du panier 13. Les extracteurs 21 présentent des bossages respectifs 23 pour la fixation de la plaque 11 par les trous 19. Selon la norme précitée, les trous 19 sont situés à une position prédéterminée du bord avant de la plaque 11 et les extracteurs respectent la distance normalisée d entre les extrémités 20 de la face avant 12 et les trous 19. Selon le mode particulier de réalisation de l'invention représenté sur les figures 1, 2 et 3, les deux extrémités haute et basse 20 de la face avant 12 prolongent la base 12a et sont pliées vers l'avant de la base 12a, puis parallèlement à une distance e de celle-ci. Ces extrémités 20 permettent la fixation des extracteurs normalisés 21 et la fixation de la plaque à la distance normalisée d. Les extracteurs normalisés 21 définissent également la position latérale de la plaque par rapport à la face avant 12, comme cela apparaît à la figure 2. Il serait aussi possible d'ajouter aux extrémités en haut et en bas de la base 12a de la face avant 12 des pièces d'extrémité respectives adaptées aux dimensions e qui vont être définies ultérieurement. Autrement, pour des cartes non normalisées, les faces avant peuvent avoir des bases 12a rectilignes sur toute leur hauteur. Par exemple, les dispositifs de fixation 21 pourraient aussi être hors normes tout en logeant dans les paniers normalisés. Selon l'exemple représenté sur la figure 5, les extrémités 20 de la face avant sont simplement des prolongements non pliés de la base 12a. Cet exemple présente l'avantage de prolonger également les ailes 12b et 12c et de renforcer ainsi la rigidité et l'isolation électromagnétique de la face avant. Un autre avantage réside dans la fixation de la plaque 11 à la face avant 12 par l'intermédiaire d'une patte 24 partant de la base 12a de la face avant 12. Cet avantage ne pouvait pas être obtenu des cartes classiques. Comme autre avantage, la face avant 12 peut simplement être fixée aux barrettes 15 du panier 13, par exemple par des vis 25 comme illustré dans la figure 5.

La plaque 11 illustrée dans les figures 1 et 2 porte un connecteur frontal classique 18a et un connecteur miniaturisé 18b. Une caractéristique d'un connecteur frontal réside dans la distance f entre sa surface avant de fixation et les points de soudure de ses pattes les plus proches de cette surface. Par exemple, pour un connecteur classique du type sub-D, la distance f = 8 mm environ ; pour un connecteur miniaturisé du type mini-D, f = 4,8 mm ; et pour un connecteur miniaturisé de type micro-D, f= 5,5 mm. La face avant 12 est disposée de telle sorte que sa base 12a soit suffisamment proche de la plaque 11 pour permettre la fixation des pattes du connecteur ayant la plus petite distance f sur la plaque 11 et sa fixation sur la base 12a (par vis, habituellement). Cette condition détermine la valeur de la distance e précitée. En d'autres termes, la distance e rapproche suffisamment la base 12a de la plaque 11 pour permettre la fixation de tous les connecteurs frontaux sur la face avant 12.

Les connecteurs frontaux 18c aux corps larges se fixent sans problème sur la base 12a de la face avant 12 de la carte 10 conforme à l'invention. Dans la majorité des cas, la largeur des connecteurs satisfait aux dimensions maximales normalisées les plus courantes. Dans l'exemple illustré, la largeur du connecteur 18c s'étend jusqu'au plan externe de l'aile 12c de la face avant 12. Les ailes ne gênent plus le logement de ce connecteur.

Dans l'exemple représenté sur les figures 1, 2 et 3, l'aile 12b latéralement plus proche de la plaque 11 porte des ressorts d'isolation électromagnétique 26. Ces ressorts sont des crochets fixés à la base de l'aile dans des lumières 27. Les lames de contact des ressorts 26 s'étendent librement hors du U à partir de l'extrémité de l'aile vers la base de la face avant. Ils sont disposés régulièrement sur toute la hauteur de l'aile. La fixation et leur disposition régulière sont des avantages offerts par l'invention. Bien entendu, d'autres moyens de fixation des ressorts à l'aile 12b sont possibles. Par exemple, la base des ressorts 26 pourrait s'accrocher à des tétons prévus sur la face interne de l'aile. L'isolation électromagnétique serait encore plus renforcée avec des ressorts 26 disposés sur toute la hauteur des grandes ailes 12b et 12c de la face avant représentée sur la figure 5. En variante, l'isolation pourrait simplement être faite en donnant aux ailes 12b et 12c une largeur déterminée par la qualité d'isolation désirée. L'invention offre l'avantage de ne pas limiter la largeur des ailes.

L'invention offre donc de multiples avantages. Elle permet la fixation de tous les connecteurs frontaux sur la face avant 12. Cette fixation peut aussi assurer la mise à la masse électrique du corps des connecteurs. Elle respecte l'intégrité des ailes et assure la rigidité désirée des faces avant, qui peuvent ainsi être faites en matériau léger et peu coûteux. Elle assure l'isolation électromagnétique désirée des faces avant montées sur un panier. Enfin, elle peut se conformer à toutes les normes concernant ces cartes et leurs paniers. Notamment, elle peut coopérer sans problème avec les cartes classiques. Les paniers peuvent donc être les paniers classiques. Cependant, grâce à l'invention, les paniers peuvent présenter des moyens d'isolation électromagnétique adaptés aux cartes conformes à l'invention, tels que ceux illustrés dans la figure 4.

Dans la figure 4, le bord droit de la surface avant du panier 13 présente une aile 28 et des ressorts d'isolation 26 disposés régulièrement sur toute la hauteur du bord. L'aile 28 est destinée à coopérer avec l'aile 12c de la face avant 12 de la carte 10 voisine pour l'isolation électromagnétique désirée. Les ressorts 26 jouent le même rôle que les ressorts 26 d'une face avant de carte conforme à l'invention. Il est clair que les moyens d'isolation du bord du panier peuvent être seulement constitués soit de l'aile 28, soit des ressorts 26. Grâce à l'invention, les ressorts 26 du bord du panier peuvent être fixés au bord et disposés régulièrement sur le bord tout en remplissant efficacement leur rôle d'isolation. L'autre bord latéral, à gauche des dessins de la figure 4, peut simplement présenter l'aile 28, comme illustré. Les ailes 28 peuvent être intégrées aux parois latérales du panier ou fixées sur elles. D'une manière générale, le ou les paniers 13 de la machine 14 peuvent être dissociables de la machine, ou bien être intégrés au moins partiellement à la machine. Des parties de l'armoire de la machine peuvent en effet remplir des fonctions analogues à au moins des parties de panier. L'invention concerne donc aussi les machines 14.

## Revendications

1. Carte de circuits imprimés (10) comprenant une plaque de circuits imprimés (11) pourvue d'un panneau de face avant (12) en forme de U le panneau comportant une base (12a) et deux ailes (12b, 12c) parallèles à la plaque, caractérisée en ce que les ailes (12b, 12c) du panneau sont placées de l'autre côté de la plaque (11) par rapport à la base (12a) du panneau.

2. Carte selon la revendication 1, caractérisée en ce que les extrémités (20) du panneau de face avant (12) sont des extensions parallèles à la base (12a) à une distance (e) vers l'avant de celle-ci.

3. Carte selon la revendication 1 ou 2, caractérisée en ce que la plaque (11) porte les pattes de connecteurs frontaux (18) et le corps de ces connecteurs est fixé à la base (12a) du panneau de face avant.

4. Carte selon la revendication 3, caractérisée en ce que les extrémités (20) de la base (12a) du panneau recevant des dispositifs de fixation (21) définissent une distance (d) entre les extrémités (20) et les points de fixation (19) de la plaque (11) et en ce que la distance (e) est déterminée par la distance minimale (f) entre les pattes des connecteurs frontaux et la base (12a) de la face avant.

5. Carte selon l'une des revendications 1 à 4, caractérisée en ce qu'une aile (12b, 12c) porte au moins un ressort d'isolation (26).

6. Carte selon la revendication 5, caractérisée en ce que chaque ressort (26) est fixé à l'aile à une position prédéterminée.

7. Carte selon l'une des revendications 1 à 4, caractérisée en ce que les ailes (12b, 12c) ont une largeur déterminée par la qualité d'isolation désirée.

8. Panier (13) pour cartes de circuits imprimés, caractérisé en ce qu'au moins un bord de sa surface avant présente des moyens d'isolation électromagnétique (26, 28) adaptés à une carte telle que définie précédemment.

9. Panier selon la revendication 8, caractérisé en ce que les moyens d'isolation comprennent une aile (28) et/ou des ressorts (26).

10. Machine de traitement de signaux (14), comprenant au moins un panier (13) pour cartes de circuits imprimés (10), caractérisée en ce qu'au moins une desdites cartes est définie par l'une des revendications 1 à 7 et/ou le panier est celui défini par la revendication 8 ou 9.

## Patentansprüche

1. Gedruckte Leiterkarte (10) mit einer gedruckten Schaltungsplatte (11), die mit einem U-förmigen Vorderpaneel (12) versehen ist, wobei das Paneel eine Basis (12a) und zwei zu der Platte parallele Flügel (12b, 12c) aufweist, dadurch gekennzeichnet, daß die Flügel (12b, 12c) des Paneels bezüglich der Basis (12a) des Paneels an der anderen Seite sitzen.

2. Karte nach Anspruch 1, dadurch gekennzeichnet, daß die Enden (20) des Vorderpaneels (12) zu der Basis (12a) in einem Abstand (e) von dieser nach vorne parallele Ansätze sind.

3. Karte nach Anspruch 1 oder 2, dadurch gekennzeichnet, daß die Platte (11) die Klammern von Stirnverbindern (18) trägt, und daß der Körper dieser Verbinder an der Basis (12a) des Vorderpaneels befestigt ist.

4. Karte nach Anspruch 3, dadurch gekennzeichnet, daß die Befestigungseinrichtungen (21) aufnehmenden Enden (20) der Basis (12a) des Paneels einen Abstand (d) zwischen den Enden (20) und den Befestigungspunkten (19) für die Platte (11) begrenzen, und daß der Abstand (e) durch den minimalen Abstand (f) zwischen den Klammern der Stirnverbinder und der Basis (12a) der Vorderseite bestimmt ist.

5. Karte nach einem der Ansprüche 1 bis 4, dadurch gekennzeichnet, daß ein Flügel (12b, 12c) wenigstens eine Isolierfeder (26) trägt.

6. Karte nach Anspruch 5, dadurch gekennzeichnet, daß jede Feder (26) an einer vorbestimmten Position an dem Flügel befestigt ist.

7. Karte nach einem der Ansprüche 1 bis 4, dadurch gekennzeichnet, daß die Flügel (12b, 12c) für die gewünschte Isolierqualität eine bestimmte Breite aufweisen.

8. Paneel (13) für gedruckte Schaltungskarten, dadurch gekennzeichnet, daß wenigstens ein Rand seiner Vorderfläche elektromagnetische Isoliermittel (26, 28) aufweist, die an eine oben definierte Karte angepaßt sind.

9. Paneel nach Anspruch 8, dadurch gekennzeichnet, daß die Isoliermittel einen Flügel (28) und/oder Federn (26) aufweisen.

10. Signalverarbeitungsmaschine (14) mit wenigstens einem Paneel (13) für gedruckte Schaltungskarten (10), dadurch gekennzeichnet, daß wenigstens eine der Karten durch einen der Ansprüche 1 bis 7 definiert ist, und/oder daß das Paneel das durch Anspruch 8 oder 9 definierte ist.

## Claims

1. A printed circuit board (10) comprising a printed circuit module (11) provided with a U-shaped front face panel (12), the panel comprising a base (12a) and two wings (12b, 12c) parallel to the module, characterised in that the wings (12b, 12c) of the panel are positioned on the other side of the module (11) from the base (12a) of the panel.

2. A board according to Claim 1, characterised in that the ends (20) of the front face panel (12) are extensions parallel to the base (12a) at a distance (e) towards the front of the latter.

3. A board according to Claim 1 or 2, characterised in that the module (11) carries the front connector tabs (18) and the body of these connectors is fastened to the base (12a) of the front face panel.

4. A board according to Claim 3, characterised in that the ends (20) of the base (12a) of the panel receiving fastening devices (21) define a distance (d) between the ends (20) and the fastening points (19) of the module (11) and in that the distance (e) is determined by the minimum distance (f) between the tabs of the front connectors and the base (12a) of the front face.

5. A board according to one of Claims 1 to 4, characterised in that one wing (12b, 12c) carries at least one insulation spring (26).

6. A board according to Claim 5, characterised in that each spring (26) is fastened to the wing in a predetermined position.

7. A board according to one of Claims 1 to 4, characterised in that the wings (12b, 12c) have a width determined by the desired insulation quality.

8. A subrack (13) for printed circuit boards, characterised in that at least one edge of its front surface has electromagnetic insulation means (26, 28) suited to a board as defined previously.

9. A subrack according to Claim 8, characterised in that the insulation means comprise a wing (28) and/or springs (26).

10. A signal-processing machine (14), comprising at least one subrack (13) for printed circuit boards (10), characterised in that at least one of said boards is defined by one of Claims 1 to 7 and/or the subrack is that defined by Claim 8 or 9.
